# EUROPÄISCHE PATENTSCHRIFT

(11) **EP 0 381 207 B1**
(45) Veröffentlichungstag und Bekanntmachung des Hinweises auf die Patenterteilung: **23.03.1994**
(21) Anmeldenummer: 90101986.9
(22) Anmeldetag: 01.02.1990
(51) Int. Cl.: H01L 21/76, H01L 21/265

(54) **Amorphisierungsverfahren zur Strukturierung eines Halbleiterkörpers**
Process of amorphisation to structure semiconductor body
Procédé d'amorphisation pour la structuration d'un corps semi-conducteur

(30) Priorität: 02.02.1989 DE 3903121
(43) Veröffentlichungstag der Anmeldung: 08.08.1990
(73) Patentinhaber: Licentia Patent-Verwaltungs-GmbH, 60596 Frankfurt (DE)
(72) Erfinder: König, Ulf, Dr.-Ing., D-7900 Ulm (DE); Kuisl, Maximilian, Dr.rer.nat., D-7900 Ulm (DE)
(74) Vertreter: Amersbach, Werner, Dipl.-Ing.

(56) Entgegenhaltungen:
- DD-A- 2 007 693
- DE-A- 2 920 763
- US-A- 3 897 273
- UND- ODER- NOR + STEUERUNGSTECHNIK. vol. 18/21, no. 12, 1988, MAINZ DE Seiten 22 - 25; U. KÖNIG: "Dreidimensionale Integration-Konzepte für multifunktionale ICs"
- ELECTRONICS LETTERS. vol. 14, no. 15, Juli 1978, ENAGE GB Seiten 460 - 462; J. A. YASAITIS: "Ion implantation of neon in silicon for planar amorphous isolation"

## Beschreibung

Die Erfindung betrifft ein Amorphisierungsverfahren zur Strukturierung eines Halbleiterkörpers nach Patentanspruch 1.

Die Erfindung findet Verwendung bei der Herstellung von zwei- oder dreidimensionalen, integrierten Schaltungen oder bei der Herstellung von Einzelbauelementen wie Dioden, Transistoren u.a. Halbleiterbauelementen.

Die Amorphisierungs-Implantation wird in der Bauelementherstellung verwendet. In der DE-OS 35 27 098 ist ein Verfahren zur Erhöhung des Emitterwiderstandes angegeben, bei dem vor der Ionenimplantation für den Emitterbereich eine Amorphisierung des Bereichs durch Implantation von nicht dotierend wirkenden Ionen durchgeführt wird. Die Dosis und Energie bei der Implantation wird so eingestellt, daß Amorphisierung im gewünschten Bereich eintritt, aber nach später folgender Temperung keine übermäßigen Kristallgitterschäden auftreten. Dadurch wird der sogenannte Channeling Effekt im amorphen Material unterdrückt und die Diffusion der Dotierstoffe bei nachfolgenden Temperaturschritten gebremst.

Die herkömmliche Separation von Halbleiterbauelementen in einer Schichtenfolge erfolgt durch Implantation von z.B. Fe, H⁺ oder O in einkristalline Halbleiterbreiche der Schichtenfolge zur Erzeugung von hochohmigen Zonen, die aktive Bauelementbereiche voneinander trennen oder durch Ätzen von Gräben um das jeweilige Bauelement in der Halbleiterschichtenfolge.

Aus DD-A-2007693 ist ein Verfahren zur Herstellung hochohmiger Bereiche in einer einkristallinen Halbleiterschicht bekannt. Durch Ionenimplantation werden amorphe Bereiche hergestellt.

In U.König, Und oder Nor + Steuerungstechnik, Vol. 18/21, No. 12, 1988, Maint, S. 22-25 wird die Herstellung von 3D-Bauelementen beschrieben. Die Isolierung der Bauelemente und der elektrischen Zuleitungen wird durch Poly-Silizium erreicht

Der Erfindung liegt die Aufgabe zugrunde, ein Verfahren anzugeben, mit dem in verfahrenstechnisch einfacher und ökonomischer Weise die Strukturierung und elektrische Isolierung von Halbleiterbauelementen und die Herstellung von elektrischen Zuleitungen zu den Halbleiterbauelementen realisierbar ist.

Diese Aufgabe wird gelöst durch die im Patentanspruch 1 angegebenen Merkmale. Vorteilhafte Ausgestaltungen und Weiterbildungen sind den Unteransprüchen zu entnehmen.

Die Erfindung hat den Vorteil, daß insbesondere bei den mit der differentiellen Epitaxie hergestellten Bauelementen und Schaltungen in den polykristallinen Bereichen Leiterbahnen ausgebildet werden, die sowohl planar an der Oberfläche der Bauelemente angeordnet sind als auch in der Bauelementschichtenfolge vergraben sein können. Dabei kann die Amorphisierung des Halbleitermaterials der Schichtenfolge im Wechsel mit einer Niedertemperaturabscheidung von weiteren Halbleiterschichten erfolgen.

Die Erfindung wird im folgenden anhand von Ausführungsbeispielen beschrieben unter Bezugnahme auf schematische Zeichnungen.

In den Fig. 1 bis 3 und 8 sind verschiedene Möglichkeiten der Bauelementisolierung durch amorphisierte Zonen in einer Halbleiterschichtenfolge dargestellt.

In den Fig. 4 bis 6 und 9 ist die Herstellung von elektrischen Zuleitungen für aktive Bauelemente in einer Schichtenfolge durch die bereichsweise Amorphisierung von Halbleiterbereichen dargestellt.

Die Fig. 7a bis 7d zeigen dreidimensional in einer Schichtenfolge angeordnete Halbleiterbauelemente, die durch amorphisierte, hochohmige Zonen isoliert sind und deren elektrische Zuleitungen in der Halbleiterschichtenfolge durch bereichsweise Amorphisierung der elektrisch leitenden, polykristallinen Bereiche gebildet werden.

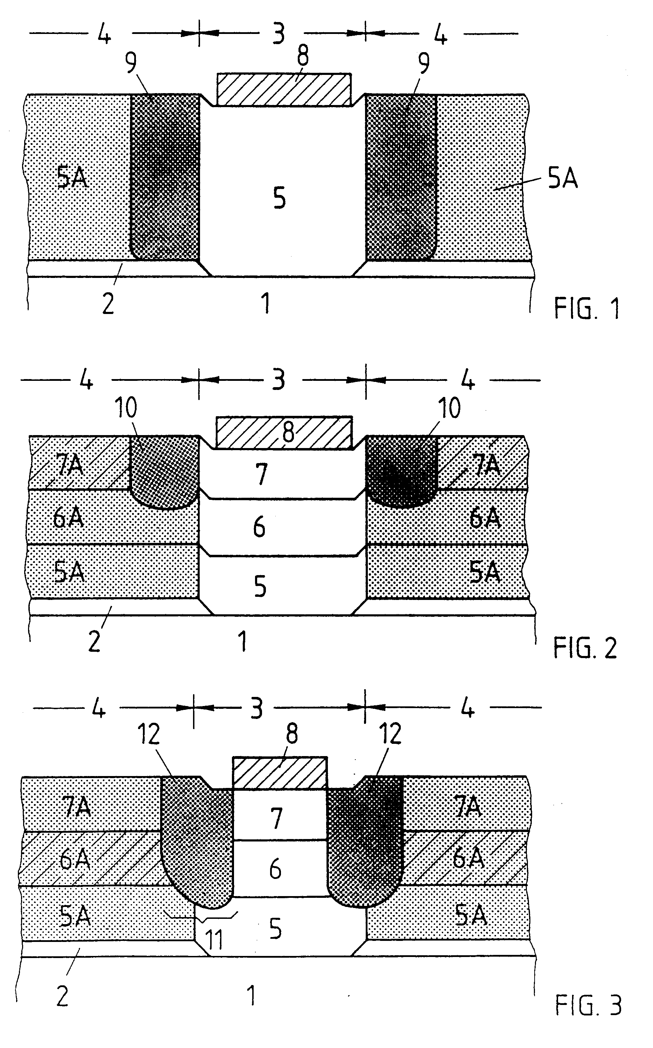

Gemäß den Fig. 1 bis 3 wird auf einem einkristallinen Halbleitersubstrat 1 aus z. B. Si oder GaAs eine amorphe Schicht 2 aus z.B. SiO₂ aufgebracht und derart strukturiert, daß das Halbleitersubstrat 1 teilweise freiliegt. Anschließend werden durch differentielle Epitaxie-Verfahren, beispielsweise mit der Molekularstrahl-Epitaxie (MBE) ein- und polykristalline Halbleiterbereiche 3,4 auf dem freiliegenden Halbleitersubstrat und auf der amorphen Schicht 2 hergestellt. Der einkristalline Halbleiterbereich 3 bildet den aktiven Bauelementbereich. Die Herstellung von Halbleiterbauelementen aus einer Schichtenfolge aus ein- und polykristallinen Bereichen ist u.a. in den DE-OS 35 45 238 und DE-OS 35 45 242 beschrieben.

In Fig. 1 besteht der aktive Bauelementbereich lediglich aus einer leitenden Einzelschicht 5, z.B.aus einer n⁺-dotierten Si-Schicht mit einer Ladungsträgerkonzentration von ungefähr 5·10¹⁸ cm⁻³ und einer Schichtdicke von etwa 0.5µm. Auf die Einzelschicht 3 ist ein metallischer Kontakt 8 aufgebracht. Der an die einkristalline Si-Schicht angrenzende polykristalline Bereich 5A aus Si ist ebenfalls n-leitend. Um den aktiven Bauelementbereich 5 von anderen leitenden Bereichen zu separieren, wird der angrenzende, leitendende, polykristalline Si-Bereich 5A teilweise durch Hochdosenimplantation mit z.B. Si oder Ge mit einer Dosis von 10¹⁴ bis 10¹⁶ cm⁻² amorphisiert. Es entstehen die hochohmigen Zonen 9 aus amorphem Si.

In Fig. 2 wird auf der amorphen Schicht 2 aus z.B. SiO₂ und dem freiliegenden Halbleitersubstrat 1 aus z.B. Si eine Schichtenfolge aus je einer n-dotierten, p-dotierten und p⁺-dotierten Si-Schicht epitaktisch aufgewachsen. Auf der amorphen Schicht 2 bilden sich polykristalline Bereiche 4 aus den polykristallinen Si-Schichten 5A, 6A, 7A und auf dem Halbleitersubstrat 1 wird der einkristalline Bauelementbereich 3 aus den einkristallinen Si-Schichten 5, 6, 7 abgeschieden. Die Leitfähigkeiten der ein- und polykristallinen Bereiche unterscheiden sich insbesondere dadurch, daß die niedrig dotierten Si-Schichten 5A, 6A im polykristallinen Bereich 4 hochohmig sind mit einem spezifischen elektrischen Widerstand von etwa 10⁵ Ωcm und die entsprechenden einkristallinen Si-Schichten 5, 6 im Bauelementenbereich niederohmig sind mit einem spezifischen elektrischen Widerstand von ungefähr 1 bis 10 Ωcm. Die hochdotierte Si-Schicht 7 bzw. 7A hat im ein- wie im polykristallinen Bereich einen spezifischen elektrischen Widerstand von etwa 10⁻² Ωcm. Ein im einkristallinen Bereich 3 hergestelltes Bauelement wäre deshalb über die leitende, polykristalline Schicht 7A mit anderen in der Schichtenfolge ausgebildeten Bauelementen kurzgeschlossen. Durch Hochdosenimplantation mit Si oder Ge mit einer Dosis von ca. 10¹⁵cm⁻² und einer Energie von z.B. 100keV wird die leitende, polykristalline Si-Schicht 7A in einem an den einkristallinen Bereich 3 angrenzenden Randbereich amorphisiert. Damit die entstehende hochohmige Zone 10 so tief ist, daß eine Isolierung der leitenden, einkristallinen Si-Schicht 7 gewährleistet ist, ist es vorteilhaft die Ionen-Implantation bis in die niedrig dotierten Si-Schichten 5A, 6A durchzuführen. Infolge der Prozeßtemperaturen findet eine teilweise Rekristallisierung in den amorphen Bereichen der Halbleiterschichtenfolge statt, so daß die Tiefe der hochohmigen Zone 10 verringert wird. Damit ein möglichst geringer Ausheilprozeß stattfindet, müssen die Prozeßtemperaturen nach der Amorphisierung niedriger als 800°C sein. Für die Herstellung von Bauelementen bzw. Schaltungen mit amorphisierten Bereichen zur Bauelementisolation eignen sich aus den o.g. Gründen insbesondere Niedertemperatur-Epitaxie-Verfahren wie z.B. die MBE oder die MOCVD (Molecular Organic Chemical Vapor Deposition). Anderenfalls trägt man der Verringerung der Amorphisierungstiefe infolge von Prozeßtemperaturen dadurch Rechnung, daß die Implantationszone anfangs tiefer als später erforderlich eingebracht wird, so daß noch der temperaturbedingten Verringerung die Tiefe der Implantationszone noch zur Isolation der Schicht ausreicht noch zur Isolation der Schicht ausreicht.

In einem weiteren Ausführungsbeispiel gemäß Fig. 3 besteht die auf dem einkristallinen Halbleitersubstrat 1 und der amorphen Schicht 2 aufgewachsene Halbleiterschichtenfolge aus je einer n-dotierten, p⁺-dotierten und n⁻-dotierten Si-Schicht. Auf dem einkristallinen Halbleitersubstrat 1 entsteht der aktive Bauelementbereich 3 mit den einkristallinen Si-Schichten 5, 6, 7 und auf der amorphen Schicht 2 bilden sich polykristalline Bereiche 4 mit den polykristallinen Si-Schichten 5A, 6A, 7A. Die gut leitenden ein- und polykristallinen Schichten 6, 6A sind zwischen niedrig dotierten, isolierenden polykristallinen Si-Schichten 5A, 7A vergraben. Um ein aus den einkristallinen Si-Schichten 5, 6, 7 bestehendes Bauelement elektrisch zu isolieren müssen hochohmige Zonen 12 im polykristallinen Bereich 4 erzeugt werden, die bis in die polykristalline Si-Schicht 5A reichen. Durch eine Hochdosenimplantation mit einer Dosis von ca. 10¹⁵cm⁻² und einer Energie von ca. 200keV werden amorphisierte, hochohmige Zonen 12 hergestellt.
Im polykristallinen Grenzbereich 11 können die hochohmigen Zonen 12 erzeugt werden (Fig. 3).

In den Fig. 4 bis 6 sind verschiedene Möglichkeiten zur Herstellung von elektrischen Zuleitungen in einem Halbleiterkörper, bestehend aus einer Halbleiterschichtenfolge entsprechend den vorherigen Ausführungsbeispielen, dargestellt. Die Strukturierung der Halbleiterschichtenfolge durch Amorphisierung von bestimmten Halbleiterbereichen ermöglicht die Herstellung von lateralen elektrischen Zuleitungen im polykristallinen Halbleitermaterial. Die in den polykristallinen Bereichen 4 des Halbleiterkörpers hergestellten elektrischen Zuleitungen verbinden die in den einkristallinen Bereichen 3 des Halbleiterkörpers ausgebildeten aktiven Bauelemente in geeigneter Weise. Für eine derartige elektrische Verbindung von Bauelementen in einer Halbleiterschichtenfolge bestehend aus ein- und polykristallinen Bereichen muß
a) zu einer hochdotierten, einkristallinen Halbleiterschicht im Bauelementbereich eine entsprechend dotierte, gut leitende Halbleiterschicht im polykristallinen Bereich und
b) zu einer gering dotierten, einkristallinen Halbleiterschicht im Bauelementbereich eine entsprechend dotierte, aber hochohmige Halbleiterschicht im polykristallinen Bereich vorliegen.

Eine gutleitende, polykristalline Halbleiterschicht kann auf eine hochohmige, polykristalline Halbleiterschicht aufgebracht werden oder zwischen hochohmige, polykristalline Halbleiterschichten eingebettet werden.

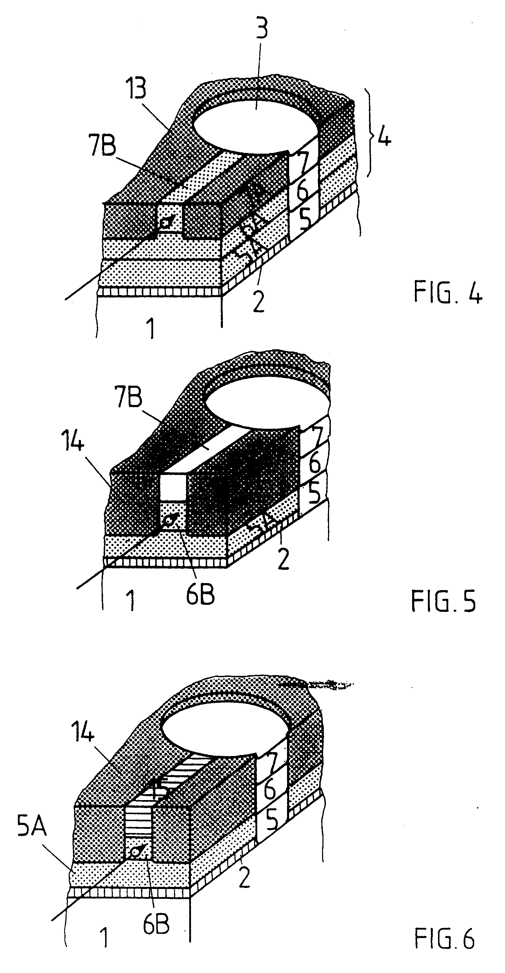

Durch eine geeignete Amorphisierung der polykristallinen Bereiche werden dann entweder in der obersten polykristallinen Halbleiterschicht der Schichtenfolge Leiterbahnen hergestellt (Fig. 4) oder die Leiterbahnen werden in der Schichtenfolge vergraben (Fig. 6). Die in den Fig. 4 bis 6 eingezeichneten Pfeile, kennzeichnen die stromführende Halbleiterschicht.

Gemäß Fig. 4 wird in einer Schichtenfolge aus einkristallinen und polykristallinen, niedrig dotierten Halbleiterschichten 5, 5A, 6, 6A und hochdotierten, ein- und polykristallinen Halbleiterschichten 7, 7A aus z.B. GaAs eine Leiterbahn 7B in der obersten, polykristallinen Halbleiterschicht 7A an der Oberfläche des Halbleiterkörpers hergestellt. Die polykristalline Halbleiterschicht 7A wird bis auf einen für eine Leiterbahn geeignet gewählten Bereich z.B. mit Elementen der III. Gruppe amorphisiert. Dabei muß die Tiefe der Hochdosenimplantation derart gewählt werden, daß ein hochohmiger Bereich 13 mit einer Tiefe großer als die Schichtdicke der Halbleiterschicht 7A entsteht. Die Leiterbahn 7B verbindet beispielsweise die einkristalline Halbleiterschicht 7 des Bauelementbereiches 3 mit weiteren in der Halbleiterschichtenfolge angeordneten Bauelementen.

Ein weiteres Ausführungsbeispiel für eine in der Schichtenfolge vergrabene Leiterbahn ist in Fig. 5 dargestellt. Die ein- und polykristallinen Halbleiterschichten 5, 5A, 7, 7A sind gering dotiert und die dazwischen angeordneten ein- und polykristallinen Halbleiterschichten 6, 6A sind gut leitend. Eine derartige n⁻p⁺n-Schichtstruktur besitzen z.B. Bipolar- oder Heterobipolartransistoren. Eine Amorphisierungszone 14 wird tiefer als die polykristalline Halbleiterschicht 6A implantiert und es bleiben die nicht amorphisierten Bereichen 6B, 7B der polykristallinen Halbleiterschichten 6A, 7A. bestehen. Da der nicht amorphisierte, polykristalline Bereich 7B der n⁻-dotierten, polykristallinen Halbleiterschicht 7A und die polykristalline gering dotierte Halbleiterschicht 5A hochohmig sind, wird der elektrische Strom lediglich im polykristallinen Bereich 6B geführt. Dieser polykristalline, leitende Bereich 6B bildet eine vergrabene Leiterbahn zur Bauelementschicht 6.
Besteht eine beispielhafte Halbleiterschichtenfolge aus n⁻-dotierten, p⁺-dotierten und n⁺-dotierten ein- und polykristallinen Halbleiterschichten 5, 5A, 6, 6A, 7, 7A aus GaAs, so wird zur Ausbildung einer Leiterbahn für die p⁺-dotierte Bauelementschicht 6 z.B. eines Bipolartransistors eine zweistufige Amorphisierung durchgeführt (Fig. 6). Zuerst wird eine amorphisierte Zone 14 senkrecht zu den polykristallinen Halbleiterschichten 6A, 7A gemäß Fig. 5 erzeugt und anschließend wird der verbleibende leitende, polykristalline Bereich 7B der polykristallinen Halbleiterschicht 7A durch Hochdosenimplantation z.B. mit einem Element der III. Gruppe in eine hochohmige amorphe Zone 15 umgewandelt. Die hochohmige, polykristalline Halbleiterschicht 5A und die hochohmigen Zonen 14, 15 gewährleisten, daß lediglich im leitenden, polykristallinen Bereich 6B elektrischer Strom geführt wird.

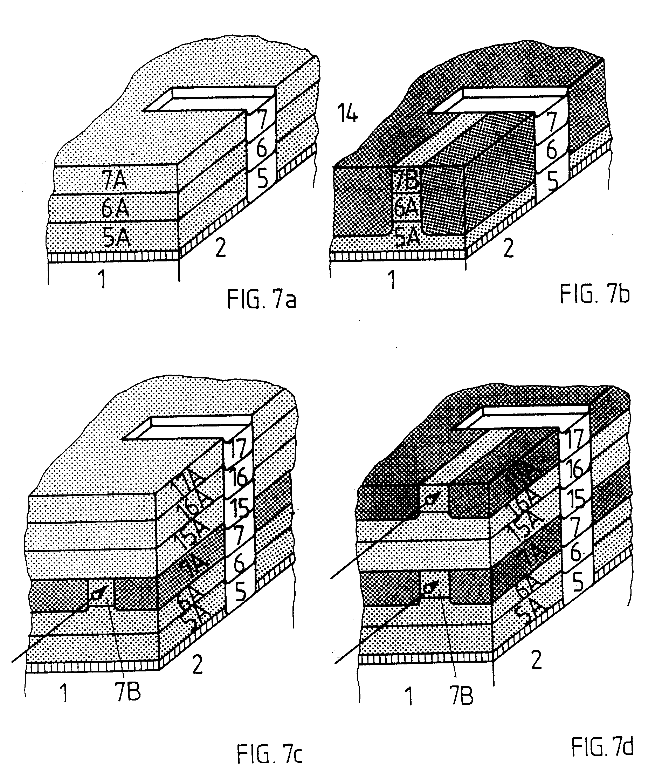

Die Herstellung von elektrischen Zuleitungen für dreidimensional in einer Halbleiterschichtenfolge angeordnete Bauelemente wird in den Fig. 7a bis 7d dargestellt. Auf einem einkristallinen Halbleitersubstrat 1 wird eine amorphe Schicht 2 aufgebracht und derart strukturiert, daß das Halbleitersubstrat teilweise freiliegt. Anschließend wird beispielsweise eine Halbleiterschichtenfolge aus ein- und polykristallinen Halbleiterschichten 5, 5A, 6, 6A, 7, 7A erzeugt (Fig. 7a). Um eine Leiterbahn in der polykristallinen Halbleiterschicht 7A herzustellen, wird eine hochohmige Zone 14 durch Hochdosenimplantation erzeugt, die bis in die polykristalline Halbleiterschicht 5A reicht (Fig. 7b). Eine derartig tiefe Amorphisierung der polykristallinen Halbleiterschichten ist erforderlich, da durch später auszuführende Epitaxie-Prozesse zur Herstellung weiterer Halbleiterschichten eine Rekristallisation im amorphiesierten Halbleitermaterial aufgrund der erforderlichen Prozeßtemperaturen stattfindet und dadurch die Tiefe der amorphisierten Zone verringert wird. Die nachfolgenden Niedertemperatur-Epitaxie-Verfahren, z.B. MBE oder MOCVD, werden vorteilhafterweise bei Temperaturen von weniger als 800°C durchgeführt, so daß lediglich ein geringer Ausheilprozeß im durch die Hochdosenimplantation zerstörten Kristallgitter des polykristallinen Halbleitermaterials stattfindet und eine genügend tiefe, hochohmige Zone 14 erhalten bleibt.
Durch teilweise Amorphisierung der polykristallinen Halbleiterschicht 7A wird die Leiterbahn 7B ausgebildet (Fig. 7b). Anschließend werden weitere Halbleiterschichten mit der MBE oder MOCVD auf die einkristalline Halbleiterschicht 7, die amorphisierte, hochohmige Zone 14 und die Leiterbahn 7B aufgewachsen. Gleichzeitig wachsen auf dem einkristallinen Bereich der Halbleiterschichtenfolge die einkristallinen Halbleiterschichten 15, 16, 17, auf der amorphisierten Zone 14 die polykristallinen Halbleiterschichten 15A, 16A, 17A und auf der polykristallinen Leiterbahn 7B ebenfalls polykristalline Halbleiterschichten 15B, 16B, 17B, die jedoch eine andere polykristalline Struktur als die auf der amorphisierten Zone 14 abgeschiedenen Halbleiterschichten 15A, 16A, 17A besitzen. Während des Epitaxie-Prozesses schrumpft die hochohmige, amorphe Zone 14 auf eine Tiefe die jedoch mindestens der Schichtdicke der Leiterbahn 7B entspricht (Fig. 7c). Anschließend können durch weitere Amorphisierungs- und Epitaxie-Prozesse Leiterbahnen und Bauelementisolierungen hergestellt werden, so daß komplexe dreidimensionale Schaltungen aufgebaut werden können (Fig. 7d).

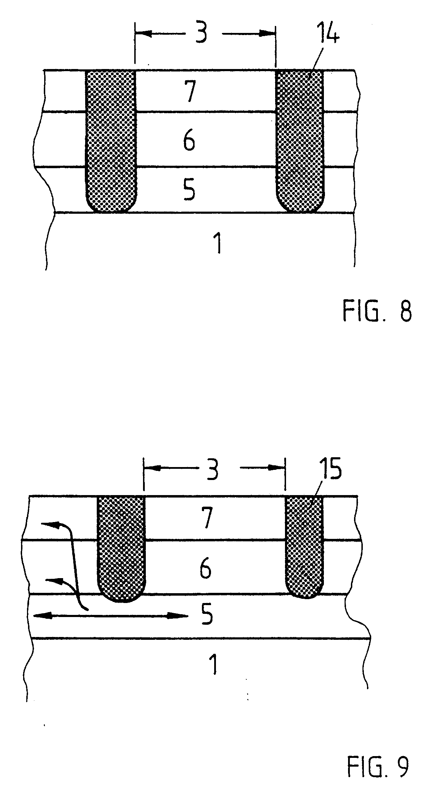

In einem Ausführungsbeispiel gemäß Fig. 8 ist eine weitere Möglichkeit zur Bauelementisolierung mit amorphen Zonen 14 angegeben. Auf einem einkristallinen Halbleitersubstrat 1 aus z.B. Si wird ganzflächig eine Halbleiterschichtenfolge aus den n⁻-dotierten, p⁻-dotierten und p⁺-dotierten Si-Schichten 5, 6, 7 aufgewachsen. Nach Abscheiden der Schichten 5, 6, 7 wird der aktive Bauelementbereich 3 durch Einbringen von amorphen Zonen 14 festgelegt. Die amorphen Zonen 14 werden durch Hochdosenimplantation mit z.B. Si hergestellt. Eine vollständige Trennung des aktiven Bauelementbereiches 3 von anderen aktiven Bauelementen wird dadurch erreicht, daß die Zonen 14 senkrecht zur gesamten Schichtenfolge verlaufen.

Eine laterale elektrische Zuleitung zum Bauelementbereich 3 in der einktristallinen Halbleiterschichtenfolge kann dadurch hergestellt werden, daß die amorphen Zonen 15 senkrecht zu den Halbleiterschichten 6, 7 verlaufen und die Halbleiterschicht 5 die elektrische Zuleitung zu den aktiven Bauelementschichten 5, 6, 7 bildet (Fig. 9).

Das erfindungsgemäße Amorphisierungsverfahren zur Strukturierung und Isolierung von Halbleiterbauelementen und deren elektrischen Verbindungen eignet sich insbesondere für die Bauelementherstellung aus Schichtenfolgen mit ein- und polykristallinen Bereichen, denn bei derartigen Schichtenfolgen werden die vorteilhaften Eigenschaften des polykristallinen Materials ausgenützt: gering dotiertes polykristallines Material isoliert und hoch dotiertes polykristallines Material ist elektrisch leitend. Die amorphisierten Zonen in einer aus ein- und polykristallinen Bereichen aufgebauten Schichtenfolge müssen nicht senkrecht zur gesamten Schichtenfolge verlaufen, wie dies in einer einkristallinen Schichtenfolge für die Bauelementisolierung erforderlich ist (Fig. 8), sondern sie müssen lediglich so tief sein, daß die elektrisch leitenden Bauelementschichten durch hochohmige, polykristalline Bereiche der Schichtenfolge von einander isoliert sind. Desweiteren hat eine aus ein- und polykristallinen Bereichen bestehende Halbleiterschichtenfolge den Vorteil, daß im polykristallinen Bereich Leiterbahnen herstellbar sind, die aus leitenden polykristallinen Halbleiterschichten bestehen und die in hochohmige polykristalline oder amorphisierte Schichten eingebettet sind.

## Patentansprüche

1. Verfahren zur Strukturierung und Isolierung eines Halbleiterkörpers bestehend aus einer Halbleiterschichtenfolge mit ein- und polykristallinen Bereichen (3, 4) in der zumindest ein aktives Halbleiterbauelement im einkristallinen Bereich (3) und entsprechende elektrische laterale Zuleitungen im polykristallinen Bereich (4) hergestellt werden, bei welchem im wesentlichen im polykristallinen Bereich (4) unterschiedlich tiefe, hochohmige amorphe Zonen (9, 10, 12, 13, 14) senkrecht zur Halbleiterschichtenfolge durch Ionenimplantation derart erzeugt werden, daß durch die amorphen Zonen die aktiven Bauelementbereiche des Halbleiterkörpers voneinander elektrisch isoliert werden und die entsprechenden elektrischen Zuleitungen (6A, 7A) im polykristallinen Bereich (4) zu den aktiven Bauelementen im Halbleiterkörper ausgebildet und voneinander elektrisch isoliert werden.

2. Verfahren nach Anspruch 1, dadurch gekennzeichnet, daß die polykristallinen Bereiche (4) der Halbleiterschichtenfolge, die an die einkristallinen Bereiche (3) angrenzen, amorphisiert werden, derart, daß senkrecht zur Halbleiterschichtenfolge unterschiedlich tiefe, hochohmige Zonen (9, 10) durch Ionenimplantation erzeugt werden.

3. Verfahren nach Anspruch 1, dadurch gekennzeichnet, daß im Grenzbereich (11) der ein- und polykristallinen Bereiche der Halbleiterschichtenfolge durch Ionenimplantation die ein- und polykristallinen Bereiche (3, 4) amorphisiert werden und unterschiedlich tiefe, hochohmige Zonen (12) erzeugt werden.

4. Verfahren nach einem der vorhergehenden Ansprüche, dadurch gekennzeichnet, daß im polykristallinen Bereich (4) der Halbleiterschichtenfolge die elektrischen Zuleitungen (6A, 7A) derart bereichsweise amorphisiert werden, daß durch die nicht amorphisierten Gebiete der leitenden polykristallinen Halbleiterschichten elektrische Zuleitungen zu den aktiven Halbleiterbauelementen des Halbleiterkörpers hergestellt werden.

5. Verfahren nach Anspruch 4, dadurch gekennzeichnet, daß die elektrischen Zuleitungen (7B) an der Oberfläche des Halbleiterkörpers angebracht werden.

6. Verfahren nach Anspruch 4, dadurch gekennzeichnet, daß die elektrischen Zuleitungen (6B) in der Halbleiterschichtenfolge vergraben angelegt werden.

7. Verfahren nach einem der vorhergehenden Ansprüche, dadurch gekennzeichnet,
- daß die Halbleiterschichtenfolge durch Abscheiden und anschließendes teilweises Amorphisieren der Halbleiterschichten derart strukturiert wird, daß dreidimensional gestapelte Halbleiterbauelemente mit entsprechenden elektrischen Zuleitungen ausgebildet werden, und
- daß die elektrischen Zuleitungen und die Halbleiterbauelemente durch hochohmige Zonen voneinander elektrisch isoliert werden.

8. Verfahren nach einem der vorhergehenden Ansprüche, dadurch gekennzeichnet, daß der ein- und polykristalline Halbleiterkörper aus Si, SiGe oder GaAs, GaAlAs hergestellt wird.

9. Verfahren nach einem der vorhergehenden Ansprüche, dadurch gekennzeichnet, daß das Halbleitermaterial des Halbleiterkörpers mit Si- oder Ge-Ionen durch Hochdosenimplantation amorphisiert wird.

10. Verfahren nach einem der vorhergehenden Ansprüche, dadurch gekennzeichnet, daß die Halbleiterschichtenfolgen mit differentiellen Niedertemperatur-Epitaxie-Verfahren gewachsen werden.

## Claims

1. Process for the structuring and insulating of a semiconductor body consisting of a semiconductor layer sequence with monocrystalline and polycrystalline regions (3, 4), in which at least one active semiconductor component in the monocrystalline region (3) and corresponding electrical lateral conductors in the polycrystalline region (4) are produced, wherein high-resistance amorphous zones (9, 10, 12, 13, 14) of different depths and perpendicular to the semiconductor layer sequence are produced substantially in the polycrystalline region (4) by ion implantation in such a manner that the active component regions of the semiconductor body are electrically insulated from one another by the amorphous zones and the corresponding electrical conductors (6A, 7A) in the polycrystalline region (4) to the active components are formed in the semiconductor body and electrically insulated from one another.

2. Process according to claim 1, characterised thereby that the polycrystalline regions (4) of the semiconductor layer sequence, which adjoin the monocrystalline regions (3), are made amorphous in such a manner that high-resistance zones (9, 10) of different depths and perpendicular to the semiconductor layer sequence are produced by ion implantation.

3. Process according to claim 1, characterised thereby that the monocrystalline and polycrystalline regions (3, 4) are made amorphous in the boundary region (11) of the monocrystalline and polycrystalline regions of the semiconductor layer sequence by ion implantation and high-resistance zones (12) of different depths are produced.

4. Process according to one of the preceding claims, characterised thereby that the electrical conductors (6A, 7A) are made amorphous regionally in the polycrystalline region (4) of the semiconductor layer sequence in such a manner that the electrical conductors to the active semiconductor components of the semiconductor body are produced by the areas of the conductive polycrystalline semiconductor layers which have not been made amorphous.

5. Method according to claim 4, characterised thereby that the electrical conductors (7B) are made at the surface of the semiconductor body.

6. Method according to claim 4, characterised thereby that the electrical conductors (6B) are laid out buried in the semiconductor layer sequence.

7. Process according to one of the preceding claims, characterised thereby that the semiconductor layer sequence is so structured through deposition and subsequent partial amorphisation of the semiconductor layers that three-dimensionally layered semiconductor components with corresponding electrical conductors are formed, and the semiconductor components are electrically insulated from one another by high-resistance zones.

8. Process according to one of the preceding claims, characterised thereby that the monocrystalline and polycrystalline semiconductor body is produced from Si and SiGe or from GaAs and GaAlAs.

9. Process according to one of the preceding claims, characterised thereby that the semiconductor material of the semiconductor body is made amorphous by Si or Ge ions through high dose implantation.

10. Process according to one of the preceding claims, characterised thereby that the semiconductor layer sequence is grown by a differential low-temperature epitaxy method.

## Revendications

1. Procédé pour la structuration et l'isolement d'un corps semi-conducteur qui comprend une succession de couches semi-conductrices avec des régions mono- et polycristallines (3, 4), procédé dans lequel on réalise au moins un composant semi-conducteur actif dans la région monocristalline (3) et des passages d'alimentation électriques latéraux correspondants dans la région polycristalline (4), et dans lequel on réalise par implantation d'ions sensiblement dans la région polycristalline (4) des zones amorphes à forte valeur ohmique et de profondeurs différentes (9, 10, 12, 13, 14) perpendiculairement à la succession des couches semi-conductrices, telles que les régions des composants actifs du corps semi-conducteur sont isolées électriquement les unes des autres par les zones amorphes, et les passages d'alimentation électrique correspondants (6A, 7A) dans la région polycristalline (4) vers les composants actifs sont réalisés dans le corps semi-conducteur et isolés électriquement les uns des autres.

2. Procédé selon la revendication 1, caractérisé en ce que les régions polycristallines (4) de la succession des couches semi-conductrices qui sont adjacentes aux régions monocristallines (3) sont rendues amorphes de telle manière que l'on produit par implantation d'ions et perpendiculairement à la succession des couches semi-conductrices des zones (9, 10) à forte valeur ohmique et de profondeurs différentes.

3. Procédé selon la revendication 1, caractérisé en ce que dans la région limite (11) des régions mono- et polycristallines de la succession des couches semi-conductrices, on rend amorphe les régions mono- et polycristallines (3, 4) par implantation d'ions et on produit des zones (12) à forte valeur ohmique et de profondeurs différentes.

4. Procédé selon l'une quelconque des revendications précédentes, caractérisé en ce que dans la région polycristalline (4) de la succession des couches semi-conductrices, on rend amorphe de manière localisée les passages électriques (6A, 7A) de telle manière que l'on produit des passages électriques vers les composants semi-conducteurs actifs du corps semi-conducteur à travers les régions qui n'ont pas été rendues amorphes des couches semi-conductrices polycristallines conductrices.

5. Procédé selon la revendication 4, caractérisé en ce que les passages électriques (7B) sont appliqués à la surface du corps semi-conducteur.

6. Procédé selon la revendication 4, caractérisé en ce que les passages électriques (6B) sont novés dans la succession des couches semi-conductrices.

7. Procédé selon l'une quelconque des revendications précédentes caractérisé en ce que:
- la succession des couches semi-conductrices est structurée par déposition et ensuite par amorphisation partielle des couches semi-conductrices de telle manière que l'on forme des composants semi-conducteurs empilés suivant trois dimensions, avec des passages électriques correspondants, et
- les passages électriques et les composants semi-conducteurs sont isolés électriquement les uns les autres au moyen de zones à forte valeur ohmique.

8. Procédé selon l'une quelconque des revendications précédentes, caractérisé en ce que le corps semi-conducteur mono- et polycristallin est réalisé en Si, SiGe ou GaAs, GaAlAs.

9. Procédé selon l'une quelconque des revendications précédentes, caractérisé en ce que le matériau semi-conducteur du corps semi-conducteur est rendu amorphe par implantation à haute dose d'ions de Si ou de Ge.

10. Procédé selon l'une quelconque des revendications précédentes, caractérisé en ce que l'on fait croître la succession des couches semi-conductrices par un procédé différentiel d'épitaxie à basse température.
